# EUROPÄISCHE PATENTSCHRIFT

(11) **EP 2 124 436 B1**
(45) Veröffentlichungstag und Bekanntmachung des Hinweises auf die Patenterteilung: **18.04.2012**
(21) Anmeldenummer: 08156857.8
(22) Anmeldetag: 23.05.2008
(51) Int. Cl.: H04N 5/64, H05K 1/14, H05K 3/36

(54) **Digitales Fernsehempfangsgerät**
Digital television reception device
Appareil de réception télévisée numérique

(43) Veröffentlichungstag der Anmeldung: 25.11.2009
(73) Patentinhaber: Novabase Digital TV Technologies GmbH, 85356 München (DE)
(72) Erfinder: Pauli, Michael, 04105 Leipzig (DE)
(74) Vertreter: Vos, Derk

(56) Entgegenhaltungen:
- EP-A- 1 814 321
- WO-A-03/085988
- WO-A1-97/46063
- DE-A1-102005 053 478
- US-A1- 2006 107 290
- US-A1- 2007 046 831
- NAKAJIMA K: "WHY USE BARE CHIP-ON-BOARD TECHNOLOGY?", ELECTRONIC PACKAGING AND PRODUCTION, CAHNERS PUBLISHING CO, NEWTON, MASSACHUSETTS, US, vol. 39, no. 4, 1 March 1999 (1999-03-01), page 37/38,40/41, XP000805955, ISSN: 0013-4945
- MULLINS B: "CHIP-ON-BOARD ASSEMBLY METHODS DIRECT CHIP ATTACHMENT IS A HIGH- PERFORMANCE AND COST-EFFECTIVE ASSEMBLY AND PACKAGING OPTION", ELECTRONIC PACKAGING AND PRODUCTION, CAHNERS PUBLISHING CO, NEWTON, MASSACHUSETTS, US, vol. 37, no. 5, 1 April 1997 (1997-04-01), page 47/48,50, XP000689089, ISSN: 0013-4945

## Beschreibung

### Gebiet der Erfindung

Die Erfindung betrifft eine Vorrichtung zum Empfang digitaler Fernsehsignale sowie ein Modul zur Datenverarbeitung für digitale Fernsehsignale.

### Hintergrund der Erfindung

Digitale Fernsehempfangsgeräte (DFEG) sind zum überwiegenden Teil als so genannte Set-Top-Boxen (STB) realisiert, die als separates Beistellgerät in der Nähe eines Wiedergabegerätes platziert werden können, etwa eines herkömmlichen Fernsehgerätes mit Bildröhre oder eines modernen Plasma- oder LCD-Displays. Diese STB können dabei prinzipiell bestehen aus den Funktionseinheiten Frontend (Tuner und Demodulator), Backend (Demultiplexer, Descrambler, programmierbarer Audio/Video- Decoder, flüchtiger Arbeitsspeicher RAM, nichtflüchtiger Programm- und Datenspeicher NVRAM), Stromversorgung, Anzeige- und Bedienelementen (LED, Infrarot-Fernbedienungsempfänger, ggf. auch Kartenleser, Tasten, numerische oder alphanumerische Anzeige), sowie verschiedenen Anschlüssen (Stromversorgung, Hochfrequenz (HF) Eingang und ggf. HF-Durchschleifäusgang, analoge und/oder digitale Video- und Audio-Ausgänge).

Set-Top-Boxen werden oft in Einplatinentechnik hergestellt, wobei sich alle elektronischen Komponenten und Anschlüsse auf einer Platine befinden. Die Platine ist dabei in der Regel mehrlagig (4 und mehr Lagen), wobei auf der Platine hoch integrierte Komponenten wie z.B. Prozessoren und Speicher als BGA (Ball Grid Array) oder SMD (Surface Mounted Device) Bauteile aufgebracht sein können, ebenso wie weitere Halbleiter (ICs und diskrete Bauelemente) und passive Komponenten in SMD Technik. Ferner können Anschluss- und Bedienelemente (Buchsen Stecker, Tasten, LED/LCD-Anzeigen) z.B. in Durchstecktechnologie montiert werden. Typische Prozessortakt- und Speichertaktfrequenzen liegen bei 50 MHz bis 500 MHz. Oft werden Metall- oder Kunststoffgehäuse oder Kombination davon verwendet.

Eine derzeitige Fertigung ist aufgrund der Mehrlagigkeit, der sehr hohen Genauigkeitsanforderungen infolge der Anschlussdichte bzw. Anschlussabstand der BGA und SMD-Komponenten mit hohen Kosten für die Platine verbunden. Dies ist bedingt durch hohe Investitionen in der Fertigungstechnik, insbesondere durch Herstellungsmaschinen, die Qualifizierung von Fachpersonal, und hohe Datensicherheitsanforderungen bei der Produktion von STB zum Empfang verschlüsselter TV-Programme, bedingt durch die notwendige Personalisierung beim finalen Funktionstest. Der erforderliche hohe Automatisierungsgrad bei der Herstellung eines komplexen Gerätes wirkt sich oft nachteilig hinsichtlich der Variabilität in der Auswahl der Fertigungsorte aus.

Darüber hinaus ist derzeit ein hoher schaltungstechnischer und gehäusetechnischer Aufwand zur Reduzierung von Emissionen parasitärer elektromagnetischer Störstrahlungen notwendig, verursacht insbesondere durch Taktleitungen (z.B. Speichertaktleitungen).

Darüber hinaus müssen bislang noch für jeden Markt spezifische Set-Top-Boxen komplett entwickelt, getestet und zertifiziert werden, wobei es auf Hardware-Ebene kaum möglich ist, Entwicklungsergebnisse wieder zu verwenden.

Aus DE 10 2005 053 478 ist eine analoge Flüssigkristallfernsehvorrichtung beschrieben, die eine erste Schaltungsleiterplatte und eine zweite Schaltungsleiterplatte aufweist, wobei die erste Schaltungsleiterplatte eine einseitige Leiterplatte enthält und die zweite Schaltungsleiterplatte eine vielschichtige Leiterplatte enthält, wobei die beiden Schaltungsleiterplatten mit einer Steckverbindung verbunden sind.

Aus US 2007/0046831 sind ein Empfangsgerät und ein Empfangssystem bekannt, bei denen verschiedene Module auf unterschiedlichen Leiterplatten vorgesehen sind.

Aus EP 1 814 321 A1 ist ein digitales Fernsehempfangsschaltkreismodul bekannt mit einem Mehrfachlayersubstrat.

Aus US 2006/0107290 ist ein digitales Rundfunkempfangsgerät bekannt mit auswechselbaren Rundfunkempfängerplatinen.

Aus WO 97/46063 ist eine vielschichtige Leiterplatine bekannt, auf der Banelemente mittels Chip on Board Technik aufgebracht sind.

### Zusammenfassung der Erfindung

Es kann als eine Aufgabe der vorliegenden Erfindung betrachtet werden, eine Vorrichtung zum Empfang digitaler Fernsehsignale sowie ein Modul zur Datenverarbeitung für digitale Fernsehsignale anzugeben, die eine größere Flexibilität hinsichtlich der Fertigung erlauben.

Die vorliegende Erfindung betrifft eine Vorrichtung zum Empfang digitaler Fernsehsignale sowie ein Modul zur Datenverarbeitung für digitale Fernsehsignale gemäß den unabhängigen Ansprüchen, wobei beispielhafte Ausführungsformen in den abhängigen Ansprüchen verkörpert sind.

Gemäß einer Ausführungsform der Erfindung wird eine Vorrichtung zum Empfang digitaler Fernsehsignale bereitgestellt, umfassend eine Hauptplatine und einen Modulplatinenanschluss, wobei der Modulplatinenanschluss an der Hauptplatine vorgesehen ist, wobei der Modulplatinenanschluss eine für einen digitalen Eingangsdatenstrom geeignete Eingangsschnittstelle und eine für ein Ausgangssignal geeignete Ausgangsschnittstelle aufweist.

Durch die Erfindung kann eine so genannte Chip on Board (COB) Technik bereitgestellt werden, mit der durch das Vorsehen eines Modulplatinenanschlusses eine Senkung der Entwicklungs-, Test- und Zertifizierungsaufwendungen, ebenso wie der Material- und Fertigungskosten erreicht werden kann. Die Module können separat vom vor-fertigen Produkt hergestellt, getestet und personalisiert werden, wodurch die Datensicherheitsanforderungen bei einer Montage des Endprodukts wesentlich geringer werden. Insbesondere kann ein Modul für bestimmte Anforderungen gefertigt werden, selbst wenn dies mit komplexen Herstellungsverfahren einhergeht. Durch einen derartigen modularen Aufbau ist quasi ein Platformprizip realisierbar, bei dem eine begrenzte Anzahl von Komponenten zu einer sehr viel größeren Anzahl von fertigen Produkten kombiniert werden kann, um so den Gesamtfertigungsaufwand für die gesamte Produktpalette zu minimieren. Ferner kann die Fertigung aufgeteilt werden in hoch- und niederkomplexe Fertigungsabschnitte. Auf diese Weise ist es nicht notwendig aufgrund nur eines begrenzten notwendigen Umfangs an komplexer Fertigung das gesamte Produkt dieser komplexen Fertigung zu unterziehen, selbst wenn ein Großteil der Fertigung einer hohen Komplexität gar nicht bedarf. Es ist ferner auch ein Modulanschluss vorgesehen für eine Spannungsversorgung bzw. einen Spannungsregler. Dies ermöglicht ebenfalls die einfache Anpassung der Vorrichtung für unterschiedliche Spannungsversorgungsnetze, beispielsweise hinsichtlich der Spannungshöhe, der Spannungsform, der Spannungsart (Gleich- oder Wechselspannung) oder der Frequenz einer Wechselspannung. Ebenso ist ein Modulanschluss realisiert für ein Frontend-Modul, auf dem die Tuner und Demodulatorkomponenten entsprechend der Anforderungen für unterschiedliche Märkte angepasst werden kann, ohne das Gesamtdesign der Hauptplatine ändern zu müssen. Auf diese Weise können ferner die digitalen Takt- bzw. Datenleitungen verkürzt werden, wodurch die gesamte Anordnung weniger Störstrahlung abgibt und auch weniger empfindlich ist gegen Störstrahlung

Gemäß einer Ausführungsform der Erfindung ist das Ausgangssignal ein Basisband-Fernsehausgangssignal wie z.B. ein analoges oder digitales Fernsehausgangssignal.

Auf diese Weise kann die gesamte Signalverarbeitung bis zum Vorliegen des Basisband-Fernsehsignals auf das Modul konzentriert werden. Das sind im Regelfall die rechenaufwendigen und auch störanfälligen Prozesse, die so auf einen Bereich eines Moduls konzentriert werden können.

Gemäß der Erfindung ist der Modulplatinenanschluss in Durchstecktechnik ausgeführt.

Auf diese Weise können vorgefertigte Platinen bzw. Module auf die Haupt- oder Trägerplatine aufgebracht werden, ohne dass eine aufwendige Montageanlage benötigt wird. Diese Technik kann auch durch weniger qualifiziertes Personal durchgeführt werden. Ferner ist diese Montagetechnik robust und stabil und kann ggf. auch manuell erfolgen.

Gemäß einer Ausführungsform der Erfindung ist der Modulplatinenanschluss in Oberflächenmontagetechnik ausgeführt.

Auf diese Weise kann eine zuverlässige Kontaktierung erreicht werden, die zudem auch noch eine geringe Bauhöhe aufweist und so zu einem insgesamt verminderten Platzbedarf für eine Set-Top-Box führen kann. Ferner kann die Fertigung auch mit einer automatischen Bestückung vorgenommen werden.

Gemäß einer Ausführungsform der Erfindung ist die Hauptplatine eine Einlagenplatine. Dabei kann beispielsweise bei Verwendung der Durchstecktechnik die Leiterebene auf Unterseite der Platine vorgesehen sein, oder bei der Verwendung der Oberflächenmontagetechnik die Leiterebene auf der Oberseite vorgesehen sein.

Eine derartige Einlagenplatine ist wesentlich einfacher in Fertigung zu handhaben und kostengünstiger herzustellen als eine Mehrlagenplatine.

Gemäß der Erfindung wird ein Modul zur Datenverarbeitung für digitale Fernsehsignale bereitgestellt, umfassend eine Modulplatine und eine für eine Datenverarbeitung für digitale Fernsehsignale geeignete Baugruppe, wobei die Modulplatine eine für einen digitalen Eingangsstrom geeignete Eingangsschnittstelle und eine für ein Ausgangssignal geeignete Ausgangsschnittstelle aufweist, wobei die Baugruppe einen mit der Eingangsschnittstelle verbundenen Eingang und einen mit der Ausgangsschnittstelle verbundenen Ausgang aufweist.

Auf diese Weise können z.B. BGA/SMD Bauelemente konzentriert auf separaten Leiterplatinen bzw. Modulen untergebracht werden, und die Module dann auf einer Hauptplatine montiert werden beispielsweise mittels einer Kontaktierung in Durchstecktechnologie. Ebenso können eine Tuner- und Demodulationsbaugruppe als z.B. in Durchstecktechnologie montierbares Modul ausgeführt sein, deren demoduliertes digitales Ausgangssignal als serieller Datenstrom der Baugruppe auf der Modulplatine bzw. der digitalen Signal-, Datenverarbeitungs- und Dekodierbaugruppe über entsprechende Leiterbahnen auf der Hauptplatine zugeführt werden. Ferner kann auch die Stromversorgungsbaugruppe als in Durchstecktechnologie montierbares Modul ausgeführt sein, um zumindest eine Sekundärspannung im Niedrigvoltbereich bereit zu stellen.

Gemäß der Erfindung weist die Baugruppe wenigstens eine Baueinheit auf aus einer Gruppe bestehend aus einer Datenverarbeitungseinheit, einer RAM-Speichereinheit, einer Flash-Speichereinheit und einer Smartcard-Verarbeitungseinheit.

Auf diese Weise können die digitalen Takt- bzw. Datenleitungen verkürzt werden, wodurch die gesamte Anordnung weniger Störstrahlung abgibt und auch weniger empfindlich ist gegen Störstrahlung. Außerdem kann erreicht werden, dass außer einfachen seriellen digitalen Daten- und Steuersignalen keine breitbandigen und parallelen Datenbusse auf der Hauptplatine vorgesehen sein müssen. Die komplexe Verdrahtung bleibt somit auf die Modulplatine beschränkt.

Gemäß einer Ausführungsform der Erfindung weist die Datenverarbeitungseinheit wenigstens eine Baueinheit auf aus einer Gruppe bestehend aus einer Demultiplexeinheit, einer Descramblingeinheit, einer Entschlüsselungseinheit, einer MPEG Dekodierungseinheit und einer Digital/Analog Wandlereinheit.

Auf diese Weise können auf der Modulplatine die digitale Signal-, Datenverarbeitungs- und Dekodierbaugruppe angebracht sein, wobei das Modul z.B. als in Durchstecktechnologie montierbares Modul ausgeführt sein kann und alle für die Signalverarbeitung, die Datenspeicherung, die Steuerung, die Entschlüsselung, Dekodierung und Digital-Analog-Wandlung notwendigen Funktionseinheiten aufweisen kann. Derartige Module können vorgefertigt werden, um diese dann später ohne großen Aufwand auf der Träger- bzw. Hauptplatine zu platzieren.

Gemäß der Erfindung ist die Baugruppe wenigstens teilweise in einer Chip on Board Technik auf der Modulplatine aufgebracht.

Auf diese Weise kann die Bauhöhe dadurch sehr viel geringer gehalten werden, ebenso wie die Drahtweglängen, die maßgeblich auch für Störeinflüsse verantwortlich sind. Dabei kann ungewollte aber unvermeidbare Störausstrahlung stark vermindert werden, was Abschirmungsmaßnahmen entbehrlich machen kann. Dadurch kann der Kosten- bzw. Montageaufwand verringert werden. Die einmal gefertigten Baugruppen weisen in der Regel keine Kontaktierungsprobleme mehr auf, insbesondere, wenn sie gelackt oder vergossen sind.

Gemäß einer Ausführungsform der Erfindung ist wenigstens ein Teil der Baugruppe auf der Modulplatine vergossen. Gemäß einer weiteren Ausführungsform der Erfindung werden mehrere Chips bzw. Dies unter einem Stück Vergussmasse vergossen.

Auf diese Weise kann verhindert werden, dass die Anschlüsse sicherheitsrelevanter Bauteile für einen unbefugten Zugriff offen liegen. Dies ist insbesondere für Zugangsberechtigungen und Schlüssel relevant, über die eine Legitimierung eines Programmzugriffs realisiert wird. Eine Zerstörung des Vergusses hat in der Regel auch einer Zerstörung der Kontaktierung zur Folge, sodass ein Zugriff auf sicherheitsrelevante Informationen verhindert werden kann.

Gemäß der Erfindung ist die Modulplatine eine Mehrlagenplatine.

Auf diese Weise ist es möglich auf der Modulplatine auch hoch integrierte Bauteile zu platzieren und zu kontaktieren. Oftmals sind schon für die Anschlüsse einiger Bauelemente mehrlagige bzw. mehrschichtige Platinenstrukturen notwendig, um die große Anzahl der Kontakte verbinden zu können. Die mehrschichtige Platinenausführung kann auf das Modul beschränkt bleiben, um den Umfang einer komplexen Fertigung auf das Modul beschränken zu können.

Gemäß einer Ausführungsform der Erfindung ist wenigstens ein Teil der Baugruppe von einer Abschirmung derart umgeben, dass eine Verminderung von elektromagnetischen Störeinflüssen auf diesen Teil der Baugruppe erfolgt.

Obgleich eine gemäß der vorliegenden Erfindung vorgeschlagene Chip on Board (COB) Technik die Störeinflüsse schon derart reduzieren kann, dass Abschirmmaßnahmen entbehrlich sein können, kann auf diese Weise mit einer lokalen Abschirmung eine weitere signifikante Reduzierung der parasitären Störstrahlung erreicht werden, und zwar für die empfindlichen Bauteile, ohne dass die gesamte Set-Top-Box abgeschirmt werden muss. Mit anderen Worten können die ggf. notwendigen Störstrahlungsschutzmaßnahmen auf das Modul beschränkt werden, z.B. in Form einer kleinen und hocheffizienten Abschirmung, jedoch nicht mehr auf die gesamte Hauptplatine erstreckt werden.

Gemäß der Erfindung wird eine erfindungsgemäße Vorrichtung zum Empfang digitaler Fernsehsignale bereitgestellt mit einem erfindungsgemäßen Modul zur Datenverarbeitung für digitale Fernsehsignale.

Auf diese Weise kann durch den modularisierten Aufbau erreicht werden, dass die Anzahl der notwendigen Modulkontakte der Baugruppe auf der Modulplatine bzw. die digitale Signal-, Datenverarbeitungs- und Dekodierbaugruppe auf ein Minimum reduziert werden, z.B. auf Kontakte zur Stromversorgung, Kontakte zur Übernahme des demodulierten digitalen Ausgangssignals der digitalen Signal-, Datenverarbeitungs- und Dekodierbaugruppe, Kontakte zur Ausgabe der dekodierten Audio- und Videosignale, Kontakte zur Steuerung der digitalen Signal-, Datenverarbeitungs- und Dekodierbaugruppe bzw. Kontakte zum Anschluss weiterer Funktionseinheiten. Letztere können z.B. direkt auf der Hauptplatine diskret z.B. in Durchstecktechnologie montiert sein, wie z.B. eine Leseeinheit für Smartcards, eines Infrarot-Empfängers oder einer Tastenleiste. Mit anderen Worten kann eine Verdrahtung der hoch integrierten Bauteile untereinander auf der Modulebene erfolgen und die Anbindung des Moduls auf wenige Kontakte beschränkt werden.

Gemäß der Erfindung ist die Anzahl der Lagen der Hauptplatine geringer ist als die Anzahl der Lagen der Modulplatine.

Auf diese Weise können die Kosten für Herstellung der Hauptplatine und Montage des Endprodukts sinken, da nur noch die Bereiche bzw. Modulplatinen in einer Mehrlagentechnik ausgeführt werden müssen, die entsprechend hoch integrierte Bauteile aufnehmen. Die oft flächenmäßig wesentlich größere Hauptplatine kann z.B. einlagig oder zweilagig ausgeführt sein, während die im Vergleich dazu wesentlich kleinere Modulplatine auch vier und mehr Schichten aufweisen kann, je nach Anforderung. Das gilt für die Anbindung eines Tunermoduls bzw. eines Spannungsversorgungsmoduls analog.

Gemäß der Erfindung ist die Vorrichtung zum Empfang digitaler Fernsehsignale als Set Top Box ausgeführt.

Als Set-Top-Box ist dabei jedoch nicht ausschließlich ein Beistellgerät im wörtlichen Sinne zu verstehen, sondern auch ein Gerät, dass beispielsweise in einen Stecker implementiert ist, bzw. direkt an einen Stecker angebaut ist ohne externe Verbindungsleitung zwischen Stecker und Gerät, so genannte Stick-Lösungen.

Es sollte bemerkt werden, dass sich die im Folgenden beschriebenen Ausführungsformen der Erfindung gleichermaßen auf die Vorrichtungen zum Empfang digitaler Fernsehsignale als auch das Modul zur Datenverarbeitung für digitale Fernsehsignale beziehen.

Die einzelnen Merkmale können selbstverständlich auch untereinander kombiniert werden, wodurch sich zum Teil auch vorteilhafte Wirkungen einstellen können, die über die Summe der Einzelwirkungen hinausgehen.

Diese und andere Aspekte der vorliegenden Erfindung werden durch die Bezugnahme auf die hiernach beschriebenen beispielhaften Ausführungsformen erläutert und verdeutlicht.

### Kurze Beschreibung der Figuren

Beispielhafte Ausführungsformen werden im Folgenden mit Bezugnahme auf die folgenden Zeichnungen beschrieben.
Figur 1 zeigt den prinzipiellen schematischen Aufbau einer Vorrichtung zum Empfang digitaler Fernsehsignale aus dem Stand der Technik.
Figur 2 zeigt ein beispielhaftes elektrisches Blockschaltbild einer Vorrichtung zum Empfang digitaler Fernsehsignale.
Figur 3 zeit einen prinzipiellen Aufbau einer Vorrichtung zum Empfang digitaler Fernsehsignale gemäß der vorliegenden Erfindung.
Figur 4 zeigt den prinzipielle Aufbau einer Hauptplatine mit einem Modul zur Datenverarbeitung für digitale Fernsehsignale gemäß der vorliegenden Erfindung.
Figur 5 zeigt eine prinzipielle Schnittansicht einer Hauptplatine mit einem Modul zur Datenverarbeitung für digitale Fernsehsignale gemäß der vorliegenden Erfindung.
Figur 6 zeigt den prinzipiellen Aufbau einer Datenverarbeitungseinheit für eine Vorrichtung zum Empfang digitaler Fernsehsignale bzw. für ein Modul zur Datenverarbeitung für digitale Fernsehsignale.

### Detaillierte Beschreibung beispielhafter Ausführungsformen

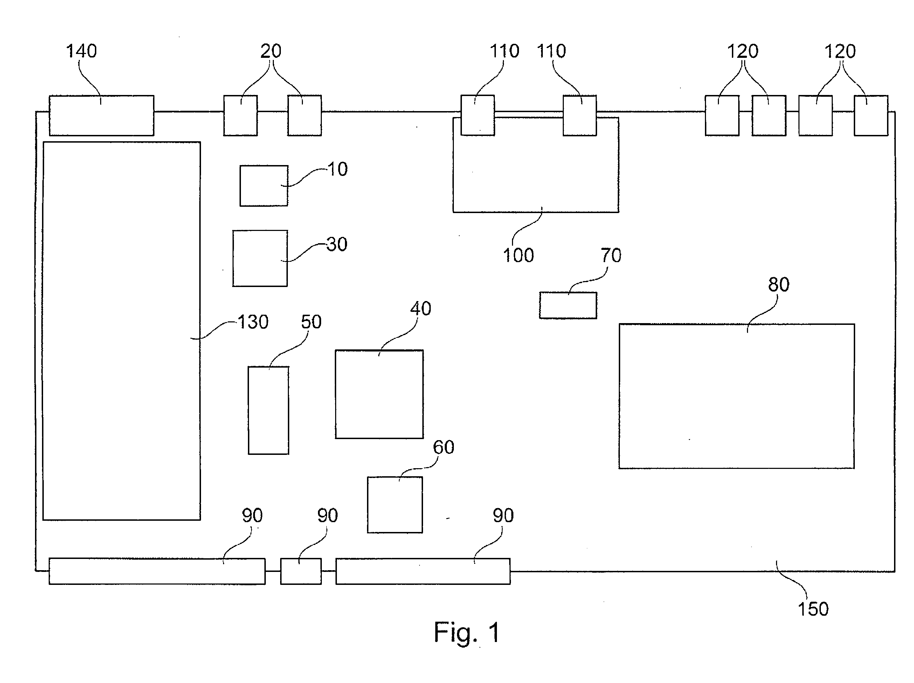

Figur 1 zeigt den prinzipiellen Aufbau einer Vorrichtung zum Empfang digitaler Fernsehsignale, beispielsweise in Form einer Set-Top-Box, in einer Aufsicht. Dabei sind auf einer Hauptplatine bzw. an einer Hauptplatine eine Vielzahl von Baugruppen und Bauelementen vorgesehen. In der in Figur 1 gezeigten Ausführung befinden sich auf der Hauptplatine 150 ein Tuner IC 10, ein Demodulator IC 30, sowie HF-Signalanschlüsse 20. Diese Komponenten werden auch als Frontend-Komponenten bezeichnet. Ferner befinden sich auf der Hauptplatine 150 ein so genannter Backend-Prozessor IC 40, ein RAM-Speicher 50, ein Flash-Speicher 60 sowie ein Smartcard IC 70. Diese Komponenten werden im Allgemeinen als Backend-Komponenten bezeichnet. Ferner sind an der Bedienvorrichtung Bedien- und Anzeigeelemente 90 vorgesehen. Weiterhin befinden sich auf der Platine eine Remodulator-Baugruppe 100, Remodulator-HF-Anschlüsse 110 sowie eine Anzahl von RCA/Toslink Audio- und Videoausgänge 120. Zur Energieversorgung sind ferner eine Stromversorgungsschaltung 130 sowie ein Stromversorgungsanschluss 140 vorgesehen.

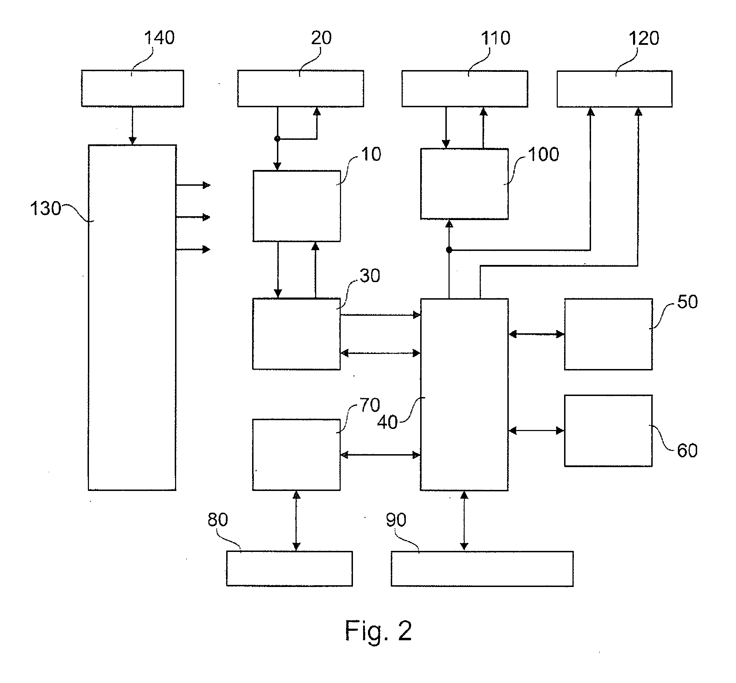

Figur 2 zeigt den strukturellen Aufbau einer Vorrichtung zum Empfang digitaler Fernsehsignale sowie deren funktionaler Zusammenhang, wobei die in Figur 1 verwendeten Bezugszeichen hier analog verwendet werden, soweit anwendbar.

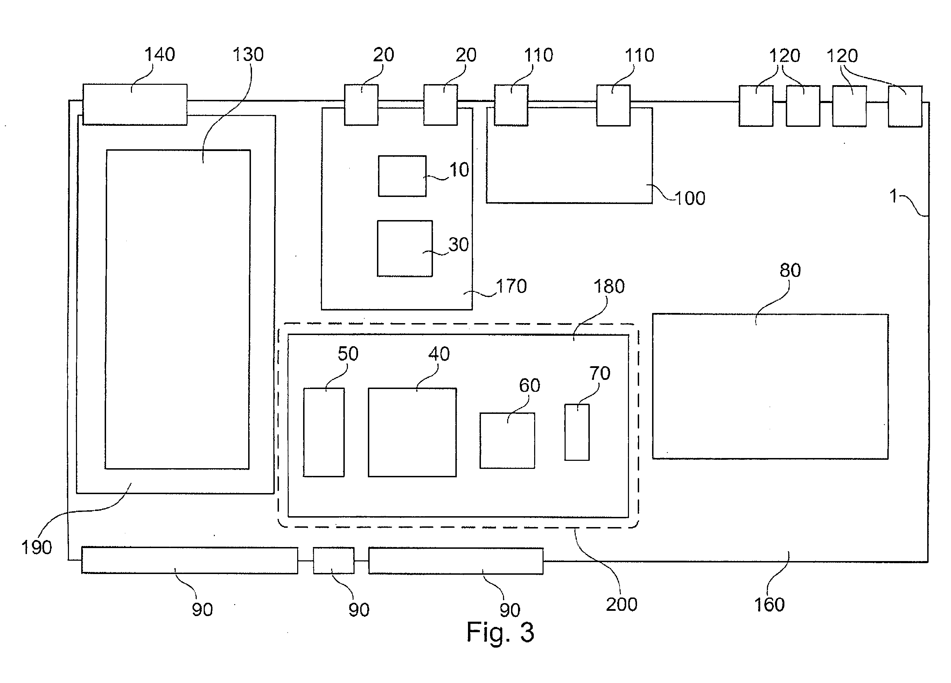

Figur 3 zeigt den prinzipiellen strukturellen Aufbau einer Vorrichtung zum Empfang digitaler Fernsehsignale, beispielsweise in Form einer Set-Top-Box gemäß der vorliegenden Erfindung. Die Vorrichtung zum Empfang digitaler Fernsehsignale 1 weist dabei eine gegenüber dem Stand der Technik anstelle der Hauptplatine 150 eine modifizierte Hauptplatine 160 auf, die funktional im Wesentlichen die üblichen Komponenten aufnimmt, die bereits mit Bezugnahme auf Figur 1 beschrieben wurden. Dabei sind jedoch im Gegensatz zum Stand der Technik verschiedene Baugruppen modular zusammengefasst und befinden sich auf separaten Modulplatinen 170, 180, 190. In der in Figur 3 gezeigten Ausführungsform befinden sich beispielsweise der Tuner IC 10 sowie der Demodulator IC 30 auf einer Tunermodulplatine bzw. auf einer Platine eines Frontend-Moduls 170. Dieses Frontend-Modul ist über die HF-Signalanschlüsse 20 von außen zugänglich, wodurch beispielsweise eine Antenne oder ein Kabelanschluss erfolgen kann. Es sei dabei angemerkt, dass eine Signaleinspeisung sowohl von erdgebundenen Systemen wie etwa DVB-T, kabelgebundenen Systemen wie etwa DVB-C als auch satellitengebundenen Systemen wie etwa DVB-S erfolgen kann. Selbstverständlich kann dies auch mit anderen digitalen Fernsehübertragungssystemen erfolgen, wie beispielsweise ISDB-T, ATSC oder MMDS gestützten Systemen. Es sei angemerkt, das die Verbindungsleitungen der einzelnen Komponenten in den Figuren 1 und 3 aus Gründen der Übersichtlichkeit weggelassen sind, jedoch funktional aus der Fig. 2 hervorgehen.

Ferner sind in der hier gezeigten Ausführungsform auf einer Platine eines Moduls zur Datenverarbeitung für digitale Fernsehsignale 180 ein Backend-Prozessor IC 40, ein RAM-Speicher 50, ein Flash-Speicher 60 sowie ein Smartcard IC 70 angeordnet. Mit anderen Worten können auf dem Modul 180 die Komponenten zur digitalen Signal-, Daten- bzw. Dekodierverarbeitung angeordnet sein. Es sei angemerkt, dass nicht zwingend alle der oben genannten Komponenten auf dem Modul zur Datenverarbeitung 180 vorgesehen sein müssen, sondern auch nur ein Teil dieser Komponenten bzw. Baugruppen dort vorgesehen sein können.

Ferner kann auch die Vorversorgungsspannungsschaltung 130 auf einem Stromversorgungsmodul 190 angeordnet sein, das über den Stromversorgungsanschluss 140 mit beispielsweise Netzspannung versorgt werden kann. Auch das Stromversorgungsmodul kann z.B. mittels Durchstecktechnik realisiert werden, ebenso wie ein Tuner- bzw. Frontend-Modul.

Dieser modulare Aufbau erlaubt es beispielsweise einzelne Komponentengruppen vorzufertigen und besonders zu spezifizieren und diese dann modular zusammen zu fügen, um entsprechende Funktionalitäten herzustellen. Dabei kann beispielsweise ein Stromversorgungsmodul in Abhängigkeit von der regionalen Netzspannung bzw. Netzfrequenz ausgelegt werden und modular an bzw. in die Vorrichtung zum Empfang digitaler Fernsehsignale eingefügt werden, wobei in diesem Fall beispielsweise die verbleibenden Komponenten im Wesentlichen unverändert beibehalten werden können. Analog gilt dieses beispielsweise auch für das Frontend-Modul 170 sowie für das Backend-Modul 180. Dabei kann beispielsweise auf die Besonderheiten unterschiedlicher Signale durch entsprechend modifizierte Frontend-Module 170 eingegangen werden, ebenso wie auf die unterschiedlichen Anforderungen und Spezifikationen bei der Datenverarbeitung für digitale Fernsehsignale durch das Backend-Modul 180.

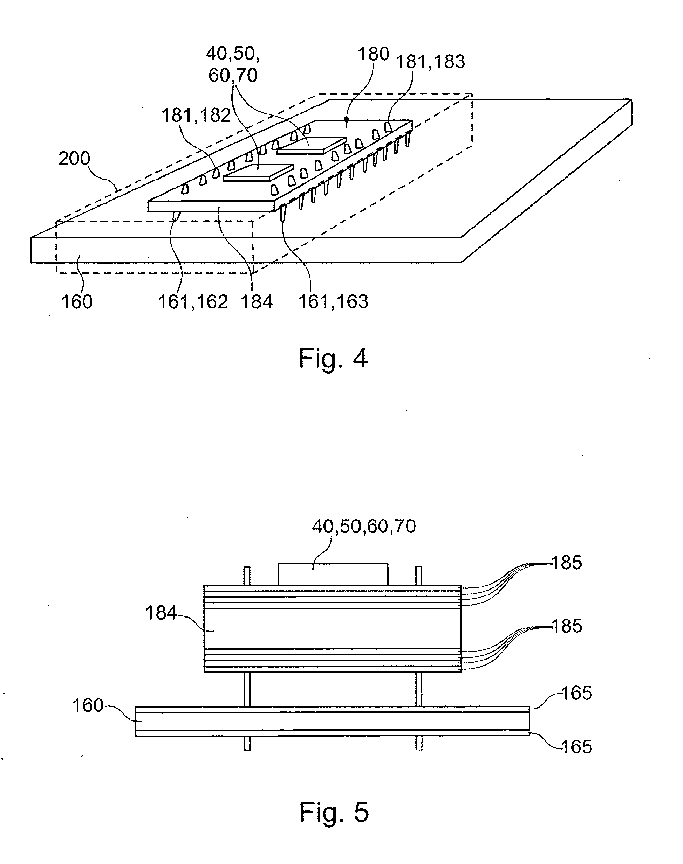

Insbesondere bei dem Backend-Modul 180 werden häufig hoch integrierte Bauteile implementiert, beispielsweise ein Backend-Prozessor IC 40, RAM-Speicher 50, Flash-Speicher 60 bzw. ein Smartcard IC 70. Diese Bauteile werden häufig mit besonderen Kontaktierungsverfahren aufgebracht, beispielsweise in einer als BGA (Ball Grid Array) Technik oder SMD (Surface Mounted Device) Technik ausgeführten Montage. Derartige Montagetechniken, insbesondere bei der Montage hoch integrierter Komponenten, erfordern in der Regel eine mehrlagige bzw. mehrschichtige Platine, bei der die einzelnen Leiterbahnen in unterschiedlichen übereinander liegenden Schichten (Layern) auf einer Seite der Platine oder auch in mehreren Schichten beidseitig der Platine geführt werden, um überhaupt eine derart große Anzahl von Kontakten und Zu- und Ableitungen führen zu können. Eine derartige Verarbeitung und Montage von hoch integrierten Komponenten auf Mehrschichtplatinen erfordert jedoch eine sehr sorgfältige und exakte Bearbeitung sowie hochspezialisierte Maschinen und Automaten. Wenn für jede Spezifikation einer Vorrichtung zum Empfang digitaler Fernsehsignale ein unterschiedliches Platinenlayout einer Hauptplatine erstellt werden müsste, wäre der Aufwand sehr groß, wobei insbesondere für die gesamte Herstellung der Vorrichtung zum Empfang digitaler Fernsehsignale komplexe Maschinen und aufwendige Verfahren angewendet werden müssen. Mit dem nun vorgeschlagenen modularen Aufbau ist es jedoch möglich, den Bereich zu verkleinern und zu konzentrieren, in dem derartige Multilayer bzw. Mehrschichtplatinen notwendig sind. Insbesondere kann beispielsweise das Backend-Modul 180 eine Platine in Mehrschichttechnik aufweisen, um die Kontaktierung und Befestigung der hoch integrierten Komponenten 40, 50, 60, 70 zu ermöglichen. Über die Definition von beispielsweise Schnittstellen bezüglich des Einganges bzw. des Ausganges kann diese Mehrschichtplatine auf eine verhältnismäßig kleinen Umfang begrenzt werden, da dieses Modul mit einer separaten Platine 184 (Figur 4 bzw. Figur 5) versehen ist. Dadurch wird es entbehrlich, die gesamte Hauptplatine 160 als Multilayer bzw. Mehrschichtplatine auszuführen, insbesondere da zahlreiche periphere Bauelemente und Baugruppen nicht zwingend einer Mehrschichtplatine zum Aufbau bedürfen. Auf diese Weise kann beispielsweise die Hauptplatine mit ihren rudimentären Bauteilen auch in Anlagen gefertigt werden, die keine so hohe Fertigungspräzision und Qualität bereitstellen, bzw. von Personal durchgeführt werden, dass keine weit reichenden Fertigkeiten und Kenntnisse in der Verarbeitung hoch integrierter Bauteile haben muss.

Ferner ist es möglich, eine Abschirmung von empfindlichen Bauteilen örtlich zu beschränken, beispielsweise auf das eigentliche Backend-Modul 180. Auf diese Weise kann auch die Abschirmung im Wesentlichen auf die relevanten Bereiche konzentriert werden und die Gehäusekomponenten für die gesamte Vorrichtung muss nicht zwingend an dem Erfordernis der Abschirmung gegen Störeinflüsse aufgerichtet sein. Vielmehr kann das Gehäuse einer Set-Top-Box aus beispielsweise Kunststoff gefertigt werden, während die störungsrelevanten Bauteile auf einer Modulplatine in einem viel kleineren räumlichen Ausmaß durch Abschirmgehäuse abgeschirmt werden können. Es sei angemerkt, dass die COB Technik eine Abschirmung unter normalen Umständen entbehrlich machen kann, unter besondern Umständen eine Abschirmung jedoch gewünscht sein kann, etwa in Umgebungen, die eine Anforderung an geringere Störstrahlung haben oder in Umgebungen, die höhere Störeinflüsse erwarten lassen.

Figur 4 zeigt einen prinzipiellen Aufbau auf einer Hauptplatine 160 mit einem darauf befindliche Modul 180 in einer perspektivischen Ansicht. Dabei weist das Modul 180 eine Modulplatine 184 auf, auf der sich beispielsweise eine Anzahl von Baugruppen oder Bauelementen 40, 50, 60, 70 befinden. Ferner sind Anschlüsse 181 vorgesehen, mit der das Modul 180 an die Hauptplatine 160 angeschlossen werden kann. Analog sind an der Hauptplatine 160 Anschlüsse 161 vorgesehen, mit denen wiederum die Anschlüsse 181 des Moduls 180 verbunden werden können. Dabei weist das Modul 180 ferner eine Eingangsschnittstelle 182 sowie eine Ausgangsschnittstelle 183 auf, wobei in der Figur 4 gezeigten Ausführungsform die Eingangsschnittstelle 182 bzw. die Ausgangsschnittstellte 183 des Moduls 180 mit einer korrespondierenden Schnittstelle 162 bzw. 163 der Hauptplatine 160 verbunden ist. Wie durch die schematische Linie angedeutet ist, kann auf diese Weise nur das Modul 180 von einer Abschirmung 200 umgeben sein, wobei diese Abschirmung 200 jedoch im Wesentlichen auf die Abmessungen des Moduls 180 beschränkt bleiben kann, ohne weitere Komponenten der Hauptplatine 160 bzw. die gesamte Hauptplatine abschirmen zu müssen. Es sei angemerkt, dass die COB Technik eine Abschirmung unter normalen Umständen entbehrlich machen kann, unter besondern Umständen eine Abschirmung jedoch gewünscht sein kann. In Abhängigkeit davon wird der Fachmann eine Abschirmung vorsehen oder nicht und eine ggf. notwendige Abschirmung dimensionieren.

Figur 5 zeigt eine Schnittansicht eines prinzipiellen Aufbaus einer Hauptplatine 160 mit einer Lage bzw. Schicht 165, in der Leiterbahnen verlaufen. Dabei kann die Lage bzw. Schicht sowohl auf der Unterseite, z.B. für die Durchstecktechnik, als auch auf der Oberseite der Platine 160, z.B. für die Oberflächenmontagetechnik, angebracht sein. Mittels Durchsteckkontakten 201 kann beispielsweise die Modulplatine 184 an bzw. auf der Hauptplatine 160 befestigt werden. Die Modulplatine 184 kann dabei mit einer mehrschichtigen (Multilayer) Struktur versehen sein, die eine Mehrzahl von Schichten bzw. Lagen 185 aufweisen kann. Dabei können die Mehrzahl von Schichten sowohl auf der Unterseite, als auch auf der Oberseite der Modulplatine 184 angeordnet sein. Die Anzahl der an der Modulplatine 184 vorgesehenen Schichten 185 ist selbstverständlich nicht auf die hier gezeigte Anzahl von vier Schichten je Seite beschränkt, sondern kann selbstverständlich auch mehr oder weniger Schichten auf jeder Seite aufweisen. Die Schichten sind voneinander isoliert, wobei in der schematischen Ansicht der Figur 5 diese Details der Übersichtlichkeit halber weggelassen sind. Ferner kann die mehrschichtige Struktur auch nur auf einer Seite der Modulplatine 184 vorgesehen sein. Auf der Modulplatine selbst können dann beispielsweise Bauelemente oder Baugruppen 40, 50, 60, 70 aufgebracht werden, die durch eine hier nicht gezeigte Kontaktierungsanordnung den Leiterbahnen in den jeweiligen Schichten 185 kontaktiert werden können.

In Beispielen, in denen die Anzahl der lagen 165 der Hauptplatine 160 der Anzahl der Lagen 185 der Modulplatine 184 entspricht, erlaubt die Modultechnik jedoch auf der Modulplatine 184 eine Kontakt- und Leiteranordnungen in kleineren Abständen als auf der Haupt- oder Trägerplatine 160. Die Montage des Moduls 180 kann auch mit der Oberflächenmontagetechnik auf der Hauptplatine erfolgen, auch wenn dies in dieser Form nicht in der Figur 5 dargestellt ist.

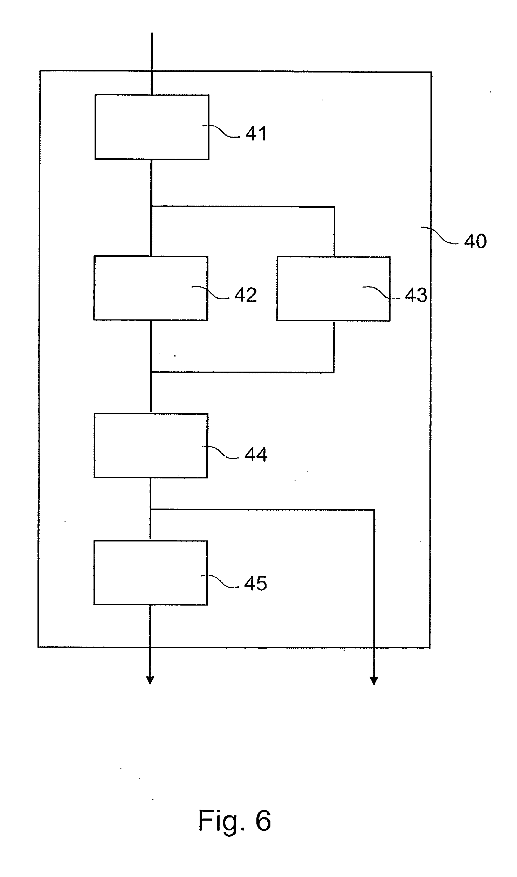

Figur 6 zeigt eine beispielhafte Struktur eines Backend-Prozessor ICs 40 bzw. allgemeiner einer Datenverarbeitungseinheit 40. Dabei kann in der Datenverarbeitungseinheit beispielsweise eine Demultiplexeinheit 41, eine Descramblingeinheit 42 oder eine Entschlüsselungseinheit 43, eine MPEG Dekodierungseinheit 44 bzw. eine Digital/Analog-Wandlereinheit 45 vorgesehen sein. Die Descramblingeinheit 42 oder die Entschlüsselungseinheit 43 können optional eingesetzt werden und sind beispielsweise für FTA (free-to-air) STB entbehrlich. Da die Descramblingeinheit 42 bereits eine Entschlüsselung implementiert hat ist nur entweder eine Descamblingeinheit 42 oder eine Entschlüsselungseinheit 43 notwenig. Figur 6 ist daher so zu verstehen, dass bei dieser Ausführungsform nicht zwingend beide Einheiten 42 und 43 vorgesehen sein müssen. Gemäß einer Ausführungsform wird beispielsweise das in die Datenverarbeitungseinheit 40 eingespeiste Signal durch eine Demultiplexeinheit und eine Descramblingeinheit aufbereitet, um ein Signal für einen Kanal zu isolieren. Das kanalisolierte Signal wird dann durch eine optionale Entschlüsselungseinheit 43 entschlüsselt und dann MPEG dekodiert, so dass ein darstellbares Fernsehsignal erhalten wird. Nach Bedarf kann dieses Signal als digitales Signal einem digitalen Fernsehgerät zugeführt werden, oder alternativ auch nach einer Digital/Analog-Umwandlung einen herkömmlichen Analogfernsehgerät zugeführt werden.

Es sollte angemerkt werden, dass die vorliegende Erfindung neben dem Empfang für digitale Fernsehsignale ebenfalls für den Empfang von digitalen Rundfunksignalen jeder Art angewendet werden kann insbesondere für jegliche Aussendung von Video und/oder Audiosignalen.

Es sei angemerkt, dass der Begriff "umfassen" weitere Elemente und Verfahrensschritte nicht ausschließt, ebenso wie der Begriff "ein" und "eine" mehrere Elemente und Schritte nicht ausschließt.

### Bezugszeichenliste

- 1: Vorrichtung zum Empfang digitaler Fernsehsignale
- 10: Tuner IC
- 20: HF-Signalanschlüsse
- 30: Demodulator IC
- 40: Backend Prozessor IC
- 41: Demultiplexeinheit
- 42: Descramblingeinheit
- 43: Entschlüsselungseinheit
- 44: MPEG Dekodierungseinheit
- 45: Digital/Analog Wandlereinheit
- 50: RAM Speicher
- 60: Flash Speicher
- 70: Smartcard IC
- 80: Smartcard-Slot
- 90: Bedien- und Anzeigeelemente
- 100: Remodulator-Baugruppe
- 110: Remodulator-HF-Anschlüsse
- 120: RCA/Toslink Audio- und Video-Ausgänge
- 130: Stromversorgungsschaltung
- 140: Stromversorgungsanschluß
- 150: Hauptplatine, herkömmlich
- 160: Hauptplatine, im Sinne der Erfindung
- 161: Modulplatinenanschluss Hauptplatinenseitig
- 162: Eingangsschnittstelle Hauptplatine
- 163: Ausgangsschnittstelle Hauptplatine
- 165: Leiterlage der Hauptplatine
- 170: Frontend-Modul
- 180: Backen-Modul
- 181: Hauptplatinenanschluss Modulseitig
- 182: Eingangsschnittstelle Modul bzw. Modulplatine
- 183: Ausgangsschnittstelle Modul bzw. Modulplatine
- 184: Modulplatine
- 185: Leiterlage der Modulplatine
- 190: Stromversorgungs-Modul
- 200: Abschirmung
- 201: Durchsteckkontakte

## Patentansprüche

1. Set Top Box mit modularem Aufbau zum Empfang digitaler Fernsehsignale umfassend:
eine Hauptplatine (160),
einen Modulplatinenanschluss (161),
ein Stromversorgungsmodul (190) mit einer Stromversorgungsschaltung (130),
ein Frontendmodul (170) mit einem Tuner (10) und Demodulatorkomponenten (30), und
ein Modul (180) zur Datenverarbeitung für digitale Fernsehsignale,
wobei der Modulplatinenanschluss an der Hauptplatine vorgesehen ist und in Durchstecktechnik ausgeführt ist,
wobei der Modulplatinenanschluss eine für einen digitalen Eingangsdatenstrom geeignete Eingangsschnittstelle (162) und eine für ein Ausgangssignal geeignete Ausgangsschnittstelle (163)aufweist,
wobei das Modul (180) eine Modulplatine (184) und eine für eine Datenverarbeitung für digitale Fernsehsignale geeignete Baugruppe (40, 50, 60, 70) aufweist,
wobei die Modulplatine (184) eine für einen digitalen Eingangsstrom geeignete Eingangsschnittstelle (182) und eine für ein Ausgangssignal geeignete Ausgangsschnittstelle (183) aufweist,
wobei die Baugruppe einen mit der Eingangsschnittstelle verbundenen Eingang und einen mit der Ausgangsschnittstelle verbundenen Ausgang aufweist,
**dadurch gekennzeichnet, dass** die Baugruppe (40, 50, 60, 70) eine Datenverarbeitungseinheit (40), eine RAM-Speichereinheit (50) eine Flash-Speichereinheit (60) und eine Smartcard-Verarbeitungseinheit (70) aufweist, die auf einer Oberfläche der einen Modulplatine wenigstens teilweise in einer Chip on Board Technik aufgebracht sind, wobei die Anzahl der Lagen (165) der Hauptplatine (160) geringer ist als die Anzahl der Lagen (185) der Modulplatine (184).

2. Set Top Box nach Anspruch 1, wobei das Ausgangssignal ein Basisband-Femsehausgangssignal ist.

3. Set Top Box nach einem der Ansprüche 1 bis 2, wobei die Hauptplatine (160) eine Einlagenplatine ist.

4. Set Top Box nach einem der Ansprüche 1 bis 3, wobei die Datenverarbeitungseinheit (40) wenigstens eine Baueinheit aufweist aus einer Gruppe bestehend aus:
- einer Demultiplexeinheit (41),
- einer Descramblingeinheit (42),
- einer Entschlüsselungseinheit (43),
- einer MPEG Dekodierungseinheit (44) und
- einer Digital/Analog Wandlereinheit (45).

5. Set Top Box nach einem der Ansprüche 1 bis 4, wobei die Datenverarbeitungseinheit (40) die Smartcard-Verarbeitungseinheit (70) sowie entweder eine Descramblingeinheit (42) oder eine Entschlüsselungseinheit (43) zum Empfang verschlüsselter Programme aufweist.

6. Set Top Box nach einem der Ansprüche 1 bis 5, wobei die Datenverarbeitungseinheit (40) wenigstens eine Demultiplexeinheit (41), eine MPEG Dekodierungseinheit (44) und eine Digital/Analog Wandlereinheit (45) aufweist.

7. Set Top Box nach einem der Ansprüche 1 bis 6, wobei wenigstens ein Teil der Baugruppe (40, 50, 60, 70) auf der Modulplatine (184) vergossen ist.

8. Set Top Box nach einem der Ansprüche 1 bis 7, wobei die Modulplatine (184) eine Mehrlagenplatine ist.

9. Set Top Box nach einem der Ansprüche 1 bis 8, wobei wenigstens ein Teil der Baugruppe (40, 50, 60, 70) von einer Abschirmung (200) derart umgeben ist, dass eine Verminderung von elektromagnetischen Störeinflüssen auf der wenigstens ein Teil der Baugruppe erfolgt.

10. SCART-Stick mit modularem Aufbau
zum Empfang digitaler Fernsehsignale umfassend:
eine Hauptplatine (160),
einen Modulplatinenanschluss (161),
ein Stromversorgungsmodul (190) mit einer Stromversorgungsschaltung (130),
ein Frontendmodul (170) mit einem Tuner (10) und Demodulatorkomponenten (30), und
ein Modul (180) zur Datenverarbeitung für digitale Fernsehsignale,
wobei der Modulplatinenanschluss an der Hauptplatine vorgesehen ist und in Durchstecktechnik ausgeführt ist,
wobei der Modulplatinenanschluss eine für einen digitalen Eingangsdatenstrom geeignete Eingangsschnittstelle (162) und eine für ein Ausgangssignal geeignete Ausgangsschnittstelle (163)aufweist,
wobei das Modul (180) eine Modulplatine (184) und eine für eine Datenverarbeitung für digitale Fernsehsignale geeignete Baugruppe (40, 50, 60, 70) aufweist,
wobei die Modulplatine (184) eine für einen digitalen Eingangsstrom geeignete Eingangsschnittstelle (182) und eine für ein Ausgangssignal geeignete Ausgangsschnittstelle (183) aufweist,
wobei die Baugruppe einen mit der Eingangsschnittstelle verbundenen Eingang und einen mit der Ausgangsschnittstelle verbundenen Ausgang aufweist,
**dadurch gekennzeichnet, dass** die Baugruppe (40, 50, 60, 70) eine Datenverarbeitungseinheit (40), eine RAM-Speichereinheit (50) eine Flash-Speichereinheit (60) und eine Smartcard-Verarbeitungseinheit (70) aufweist, die auf einer Oberfläche der einen Modulplatine wenigstens teilweise in einer Chip on Board Technik aufgebracht sind, wobei die Anzahl der Lagen (165) der Hauptplatine (160) geringer ist als die Anzahl der Lagen (185) der Modulplatine (184).

## Claims

1. A set-top box with modular construction for receiving digital television signals, comprising:
a main board (160),
a module board connector (161),
a power supply module (190) with a power supply circuit (130), a front-end module (170) with a tuner (10) and demodulator components (30), and
a module (180) for data processing for digital television signals,
wherein the module board connector is provided on the main board and is realised by means of through hole technology,
wherein the module board connector has an input interface (162) suitable for a digital input data stream and an output interface (163) suitable for an output signal,
wherein the module (180) has a module board (184) and a unit (40, 50, 60, 70) suitable for a data processing for digital television signals,
wherein the module board (184) has an input interface (182) suitable for a digital input stream and an output interface (183) suitable for an output signal,
wherein the unit has an input connected to the input interface and an output connected to the output interface,
**characterised in that** the unit (40, 50, 60, 70) has a data processing unit (40), a RAM memory unit (50), a flash memory unit (60) and a smart card processing unit (70), which are applied at least to some extent by means of chip on board technology on a surface of the one module board, wherein the number of layers (165) of the main board (160) is smaller than the number of layers (185) of the module board (184).

2. The set-top box according to Claim 1, wherein the output signal is a baseband television output signal.

3. The set-top box according to one of Claims 1 to 2, wherein the main board (160) is a single-layer circuit board.

4. The set-top box according to one of Claims 1 to 3, wherein the data processing unit (40) has at least one device out of a group, the group consisting of:
- a demultiplex unit (41),
- a descrambling unit (42),
- a decryption unit (43),
- an MPEG decoding unit (44) and
- a digital/analogue converter unit (45).

5. The set-top box according to one of Claims 1 to 4, wherein the data processing unit (40) has the smart card processing unit (70) as well as either a descrambling unit (42) or a decryption unit (43) for receiving encrypted programmes.

6. The set-top box according to one of Claims 1 to 5, wherein the data processing unit (40) has at least one demultiplex unit (41), an MPEG decoding unit (44) and a digital/analogue converter unit (45).

7. The set-top box according to one of Claims 1 to 6, wherein at least one part of the unit (40, 50, 60, 70) is cast on the module board (184).

8. The set-top box according to one of Claims 1 to 7, wherein the module board (184) is a multiple-layer circuit board.

9. The set-top box according to one of Claims 1 to 8, wherein at least one part of the unit (40, 50, 60, 70) is surrounded by a shielding (200) in such a manner that a minimisation of electromagnetic disruptive influences on the at least one part of the unit takes place.

10. A SCART stick with modular construction for receiving digital television signals, comprising:
a main board (160),
a module board connector (161),
a power supply module (190) with a power supply circuit (130),
a front-end module (170) with a tuner (10) and demodulator components (30), and
a module (180) for data processing for digital television signals,
wherein the module board connector is provided on the main board and is realised by means of through hole technology,
wherein the module board connector has an input interface (162) suitable for a digital input data stream and an output interface (163) suitable for an output signal,
wherein the module (180) has a module board (184) and a unit (40, 50, 60, 70) suitable for a data processing for digital television signals,
wherein the module board (184) has an input interface (182) suitable for a digital input stream and an output interface (183) suitable for an output signal,
wherein the unit has an input connected to the input interface and an output connected to the output interface,
**characterised in that** the unit (40, 50, 60, 70) has a data processing unit (40), a RAM memory unit (50), a flash memory unit (60) and a smart card processing unit (70), which are applied at least to some extent by means of chip on board technology on a surface of the one module board, wherein the number of layers (165) of the main board (160) is smaller than the number of layers (185) of the module board (184).

## Revendications

1. Décodeur avec structure modulaire pour la réception de signaux télévisuels numériques comprenant :
une platine principale (160),
un raccord de platine de module (161),
un module d'alimentation électrique(190) avec un circuit d'alimentation électrique(130),
un module frontal (170) avec un syntoniseur (10) et des composants de démodulateur (30), et
un module (180) de traitement de données pour signaux télévisuels numériques,
dans lequel le raccord de platine de module est prévu sur la platine principale et est réalisé selon la technique de câblage traversant,
dans lequel le raccord de platine de module présente une interface d'entrée (162) appropriée à un flux de données d'entrée numériques et une interface de sortie (163) appropriée à un signal de sortie,
dans lequel le module (180) présente une platine de module (184) et un module (40, 50, 60, 70) approprié au traitement de données pour des signaux télévisuels numériques,
dans lequel la platine de module (184) présente une interface d'entrée (182) appropriée à un flux d'entrée numérique et une interface de sortie (183) appropriée à un signal de sortie,
dans lequel le module présente une entrée reliée à l'interface d'entrée et une sortie reliée à l'interface de sortie,
**caractérisé en ce que** le module (40, 50, 60, 70) présente une unité de traitement de données (40), une unité de mémoire RAM (50), une unité de mémoire Flash (60) et une unité de traitement Smartcard (70), qui sont montées sur une surface d'une platine de module au moins partiellement selon une technique de pastillage, dans lequel le nombre de couches (165) de la patine principale (160) est inférieur au nombre de couches (185) de la platine de module (184).

2. Décodeur selon la revendication 1, dans lequel le signal de sortie est un signal de sortie télévisuel de bande de base.

3. Décodeur selon une des revendications 1 à 2, dans lequel la platine principale (160) est une platine monocouche.

4. Décodeur selon une des revendications 1 à 3, dans lequel l'unité de traitement de données (40) présente au moins une unité structurelle du groupe constitué de :
- une unité de démultiplexage (41),
- une unité de déchiffrement (42),
- une unité de décryptage (43),
- une unité de décodage MPEG (44) et
- une unité de conversion numérique/analogique (45).

5. Décodeur selon une des revendications 1 à 4, dans lequel l'unité de traitement de données (40) présente l'unité de traitement Smartcard (70) ainsi que soit une unité de déchiffrement (42), soit une unité de décryptage (43) pour recevoir des programmes cryptés.

6. Décodeur selon une des revendications 1 à 5, dans lequel l'unité de traitement de données (40) présente au moins une unité de démultiplexage (41), une unité de décodage MPEG (44) et une unité de conversion numérique/analogique (45).

7. Décodeur selon une des revendications 1 à 6, dans lequel au moins une partie du module (40, 50, 60, 70) est encapsulée sur la platine de module (184).

8. Décodeur selon une des revendications 1 à 7, dans lequel la platine de module (184) est une platine multicouches.

9. Décodeur selon une des revendications 1 à 8, dans lequel au moins une partie du module (40, 50, 60, 70) est entouré par un blindage (200) de telle sorte qu'une diminution des influences perturbatrices électromagnétiques sur au moins une partie du module soit obtenue.

10. Stick SCART avec structure modulaire pour la réception de signaux télévisuels numériques comprenant :
une platine principale (160),
un raccord de platine de module (161),
un module d'alimentation électrique(190) avec un circuit d'alimentation électrique(130),
un module frontal (170) avec un syntoniseur (10) et des composants de démodulateur (30), et
un module (180) de traitement de données pour signaux télévisuels numériques,
dans lequel le raccord de platine de module est prévu sur la platine principale et est réalisé selon la technique de câblage traversant,
dans lequel le raccord de platine de module présente une interface d'entrée (162) appropriée à un flux de données d'entrée numériques et une interface de sortie (163) appropriée à un signal de sortie,
dans lequel le module (180) présente une platine de module (184) et un module (40, 50, 60, 70) approprié au traitement de données pour des signaux télévisuels numériques,
dans lequel la platine de module (184) présente une interface d'entrée (182) appropriée à un flux d'entrée numérique et une interface de sortie (183) appropriée à un signal de sortie,
dans lequel le module présente une entrée reliée à l'interface d'entrée et une sortie reliée à l'interface de sortie,
**caractérisé en ce que** le module (40, 50, 60, 70) présente une unité de traitement de données (40), une unité de mémoire RAM (50), une unité de mémoire Flash (60) et une unité de traitement Smartcard (70), qui sont montées sur une surface d'une platine de module au moins partiellement selon une technique de pastillage, dans lequel le nombre de couches (165) de la patine principale (160) est inférieur au nombre de couches (185) de la platine de module (184).
